# EUROPEAN PATENT APPLICATION

(11) **EP 2 372 566 A1**
(43) Date of publication of application: **05.10.2011**
(21) Application number: 11002647.3
(22) Date of filing: 30.03.2011
(51) Int. Cl.: G06F 15/78

(54) **Method and system for providing 1080p video with 32-bit mobile DDR memory**

(30) Priority: 01.04.2010 US 320179 P; 28.03.2011 US 73494
(71) Applicant: Broadcom Corporation, Irvine, CA 92617 (US)
(72) Inventor: Ramsdale, Timothy, Histon, Cambridge CB24 9JL (GB)
(74) Representative: Jehle, Volker Armin

(57) **Abstract**

A method and system are provided in which a multimedia processor and a single low power double data rate memory 2 (LPDDR2) synchronous dynamic random access memory (SDRAM) coupled to the multimedia processor are disposed in a single package on a single substrate or chip. The single LPDDR2 SDRAM may be accessed by the multimedia processor via a 32-bit wide access bus. The multimedia processor and single LPDDR2 SDRAM may be operable to process video data. The video data may comprise 1080 progressive (1080p) high-definition television (HDTV) formatted data. The multimedia processor and single LPDDR2 SDRAM may be operable to pipeline process video data from an image sensor. The multimedia processor and single LPDDR2 SDRAM may be disposed in a stacked configuration in the single package.

## Description

### CROSS-REFERENCE TO RELATED APPLICATIONS/INCORPORATION BY REFERENCE

This application makes reference to, claims priority to, and claims benefit of United States Provisional Application Serial No. 61/320,179, filed April 1, 2010.

This application also makes reference to:
United States Patent Application Serial No. 12/686,800 (Attorney Docket Number 21161 US02) which was filed on January 13, 2010;
United States Patent Application Serial No. 12/953,128 (Attorney Docket Number 21162US02) which was filed on November 23, 2010;
United States Patent Application Serial No. 12/858,192 (Attorney Docket Number 21163US02) which was filed on August 25, 2010;
United States Patent Application Serial No. 12/953,739 (Attorney Docket Number 21164US02) which was filed on November 24, 2010;
United States Patent Application Serial No. 12/942,626 (Attorney Docket Number 21166US02) which was filed on November 9, 2010;
United States Patent Application Serial No. 12/953,756 (Attorney Docket Number 21172US02) which was filed on November 24, 2010;
United States Patent Application Serial No. 12/869,900 (Attorney Docket Number 21176US02) which was filed on August 27, 2010;
United States Patent Application Serial No. 12/868,508 (Attorney Docket Number 21177US02) which was filed on August 25, 2010; and
United States Patent Application Serial No. 12/835,522 (Attorney Docket Number 21178US02) which was filed on July 13, 2010.

Each of the above stated applications is hereby incorporated herein by reference in its entirety.

### FIELD OF THE INVENTION

Certain embodiments of the invention relate to communication systems. More specifically, certain embodiments of the invention relate to providing 1080p video with 32-bit mobile double data rate (DDR) memory.

### BACKGROUND OF THE INVENTION

Image and video capabilities may be incorporated into a wide range of devices such as, for example, cellular phones, personal digital assistants, digital televisions, digital direct broadcast systems, digital recording devices, gaming consoles and the like. Operating on video data, however, may be very computationally intensive because of the large amounts of data that need to be constantly moved around. This normally requires systems with powerful processors, hardware accelerators, and/or substantial memory, particularly when video encoding is required. Such systems may typically use large amounts of power, which may make them less than suitable for certain applications, such as mobile applications.

Due to the ever growing demand for image and video capabilities, there is a need for power-efficient, high-performance multimedia processors that may be used in a wide range of applications, including mobile applications. Such multimedia processors may support multiple operations including audio processing, image sensor processing, video recording, media playback, graphics, three-dimensional (3D) gaming, and/or other similar operations.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

A system and/or method for providing 1080p video with 32-bit mobile double data rate (DDR) memory, as set forth more completely in the claims.
According to an aspect, a method for video processing is provided, the method comprising:
in a mobile communication device:
   processing video data utilizing a multimedia processor communicatively coupled to a single low power double data rate memory 2 (LPDDR2) synchronous dynamic random access memory (SDRAM), wherein:
      said multimedia processor and said single LPDDR2 SDRAM are disposed in a single package on a single substrate; and
      said processing comprises accessing said single LPDDR2 SDRAM by said multimedia processor during said processing of video data.
Advantageously, said video data comprises 1080 progressive (1080p) high-definition television (HDTV) formatted video data.
Advantageously, the method further comprises accessing said single LPDDR2 SDRAM via a 32-bit wide bus access.
Advantageously, said processing comprises pipeline processing of video data from an image sensor.
Advantageously, said processing comprises encoding said pipelined processed video data.
Advantageously, said encoding comprises discrete cosine transforming of said pipelined processed video data.
Advantageously, said processing comprises formatting said encoded data for displaying.
Advantageously, said multimedia processor and said single LPDDR2 SDRAM are disposed in a stacked configuration in said single package.
Advantageously, said stacked configuration comprises a spacer layer between a substrate comprising said multimedia processor and a substrate comprising said single LPDDR2 SDRAM.
Advantageously, said single package comprises a ball grid array package.
According to an aspect, a system for video processing comprises:
   a multimedia processor for use within a mobile communication device; and
   a single low power double data rate memory 2 (LPDDR2) synchronous dynamic random access memory (SDRAM) communicatively coupled to said multimedia processor, wherein:
      said multimedia processor and said single LPDDR2 SDRAM are disposed in a single package on a single substrate,
      said multimedia processor is operable to process video data, and
      said multimedia processor is operable to access said single LPDDR2 SDRAM during said processing of video data.
Advantageously, said video data comprises 1080 progressive (1080p) high-definition television (HDTV) formatted video data.
Advantageously, said multimedia processor is operable to access said single LPDDR2 SDRAM via a 32-bit wide access bus.
Advantageously, said multimedia processor and said single LPDDR2 SDRAM are operable to pipeline process video data from an image sensor.
Advantageously, said multimedia processor and said single LPDDR2 SDRAM are operable to encode said pipelined processed video data.
Advantageously, said multimedia processor and said single LPDDR2 SDRAM are operable to discrete cosine transform of said pipelined processed video data.
Advantageously, said multimedia processor and said single LPDDR2 SDRAM are operable to format said encoded data for displaying.
Advantageously, said multimedia processor and said single LPDDR2 SDRAM are disposed in a stacked configuration in said single package.
Advantageously, said stacked configuration comprises a spacer layer between a substrate comprising said multimedia processor and a substrate comprising said single LPDDR2 SDRAM.
Advantageously, said single package comprises a ball grid array package.

Various advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1A is a block diagram of an exemplary multimedia system that is operable to provide video processing, in accordance with an embodiment of the invention.

FIG. 1B is a block diagram of an exemplary multimedia processor that is operable to provide video processing, in accordance with an embodiment of the invention.

FIG. 1C is a block diagram of an exemplary multimedia processor and a LPDDR2 SDRAM in a single integrated circuit, in accordance with an embodiment of the invention.

FIG. 1D is a block diagram of an exemplary multimedia processor and a LPDDR2 SDRAM in a single integrated circuit, in accordance with another embodiment of the invention.

FIG. 2 is a block diagram that illustrates an exemplary video processing core architecture for use in a multimedia processor, in accordance with an embodiment of the invention.

FIG. 3 is a block diagram that illustrates an exemplary single package comprising a multimedia processor and an LPDDR2 SDRAM, in accordance with an embodiment of the invention.

FIG. 4 is a cross-sectional view of an exemplary stacked configuration of a multimedia processor and an LPDDR2 SDRAM in a single ball grid array package, in accordance with an embodiment of the invention.

FIG. 5 is a flow chart that illustrates an exemplary usage case for processing data from a video recorder utilizing a multimedia processor and an LPDDR2 SDRAM in a single package, in accordance with an embodiment of the invention.

FIG. 6 is a flow chart that illustrates an exemplary video processing operation of a multimedia processor and an LPDDR2 SDRAM in a single package, in accordance with an embodiment of the invention.

### DETAILED DESCRIPTION OF THE INVENTION

Certain embodiments of the invention can be found in a method and system providing 1080p video with 32-bit mobile double data rate (DDR) memory. In accordance with various embodiments of the invention, a method for video processing may comprise processing video data utilizing a multimedia processor communicatively coupled to a single low power double data rate memory 2 (LPDDR2) synchronous dynamic random access memory (SDRAM), wherein the multimedia processor and the single LPDDR2 SDRAM are disposed in a single package on a single substrate. The processing may comprise accessing the single LPDDR2 SDRAM by the multimedia processor during the processing of video data. The single LPDDR2 SDRAM may comprise a 32-bit wide access bus. In this regard, the multimedia processor may be operable to access the LPDDR2 SDRAM utilizing a 32-bit wide bus access. The video data that is being processed may comprise 1080 progressive (1080p) high-definition television (HDTV) formatted video data.

The processing of video data may comprise pipeline processing of video data from an image sensor. The processing of video data may comprise encoding the pipelined processed video data. The encoding may comprise discrete cosine transforming of the pipelined processed video data. The processing of video data may comprise formatting the encoded data for displaying.

The multimedia processor and the single LPDDR2 SDRAM may be disposed in a stacked configuration in the single package on the single substrate. The stacked configuration may comprise a spacer layer between a substrate comprising the multimedia processor and a substrate comprising the single LPDDR2 SDRAM. The single package may comprise a ball grid array package. In an embodiment of the invention, the multimedia processor and the single LPDDR2 SDRAM, which are disposed in the single package, are within a mobile communication device such as a Smartphone, for example. In this regard the single package may be an integrated circuit (IC) or chip within the mobile communication device.

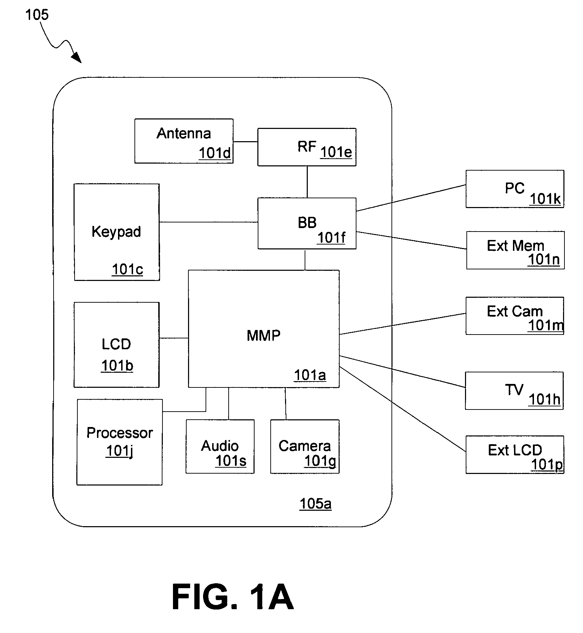

FIG. 1A is a block diagram of an exemplary multimedia system that is operable to provide video processing, in accordance with an embodiment of the invention. Referring to FIG. 1A, there is shown a mobile multimedia system 105 that comprises a mobile multimedia device 105a, a television (TV) 101h, a personal computer (PC) 101k, an external camera 101m, external memory 101n, and external liquid crystal display (LCD) 101p. The mobile multimedia device 105a may be a handheld device capable of handling computing and/or communication operations, such as a mobile phone, a personal digital assistant, a tablet, or other like device. The mobile multimedia device 105a may be a mobile computing device The mobile multimedia device 105a may comprise a mobile multimedia processor (MMP) 101a, an antenna 101d, an audio block 101s, a radio frequency (RF) block 101e, a baseband processing block 101f, an LCD 101b, a keypad 101c, and a camera 101g.

The MMP 101a may comprise suitable circuitry, logic, interfaces, and/or code that may be operable to perform video and/or multimedia processing for the mobile multimedia device 105a. The MMP 101a may also comprise integrated interfaces, which may be utilized to support one or more external devices coupled to the mobile multimedia device 105a. For example, the MMP 101a may support connections to a TV 101h, an external camera 101m, and an external LCD 101p.

The processor 101j may comprise suitable circuitry, logic, interfaces, and/or code that may be operable to control processes in the mobile multimedia system 105. Although not shown in FIG. 1A, the processor 101j may be coupled to a plurality of devices in and/or coupled to the mobile multimedia system 105.

In operation, the mobile multimedia device may receive signals via the antenna 101d. Received signals may be processed by the RF block 101e and the RF signals may be converted to baseband by the baseband processing block 101f. Baseband signals may then be processed by the MMP 101a. Audio and/or video data may be received from the external camera 101m, and image data may be received via the integrated camera 101g. During processing, the MMP 101a may utilize the external memory 101n for storing of processed data. Processed audio data may be communicated to the audio block 101s and processed video data may be communicated to the LCD 101b and/or the external LCD 101p, for example. The keypad 101c may be utilized for communicating processing commands and/or other data, which may be required for audio or video data processing by the MMP 101a.

In an embodiment of the invention, the MMP 101a may be operable to process 1080 interlaced (1080i) and/or 1080p HDTV formatted video data. The number 1080 in both 1080i and 1080p denotes the number of horizontal scan lines, with interlaced and progressive referring to the type of scan utilized. The MPP 101a may be operable to support, for example, native 1080p and/or upscaled 1080p in which lower resolution video may be reformatted for higher resolution display. Interlaced video may also be displayed as progressive video after being deinterlaced.

To support various video processing operations the MMP 101a may utilize a single memory with narrower bus width and higher bus speed than multiple memories having a wider bus width and slower bus speed. For example, the MMP 101a may utilize a single LPDDR2 SDRAM to support various video processing operations, including the processing of video data comprising 1080p formatted video data. In this regard, the MMP 101a, or at least a portion thereof, and the single LPDDR2 SDRAM may be disposed in a single package. Moreover, the MMP 101a, or at least a portion thereof, and the single LPDDR2 SDRAM may be disposed in a single package in a stacked configuration, for example. In an embodiment of the invention, the multimedia processor 101a and the single LPDDR2 SDRAM, which are disposed in the single package, are within the mobile multimedia device 105a. In this regard, the single package may comprise an IC or chip within the mobile multimedia device 105a.

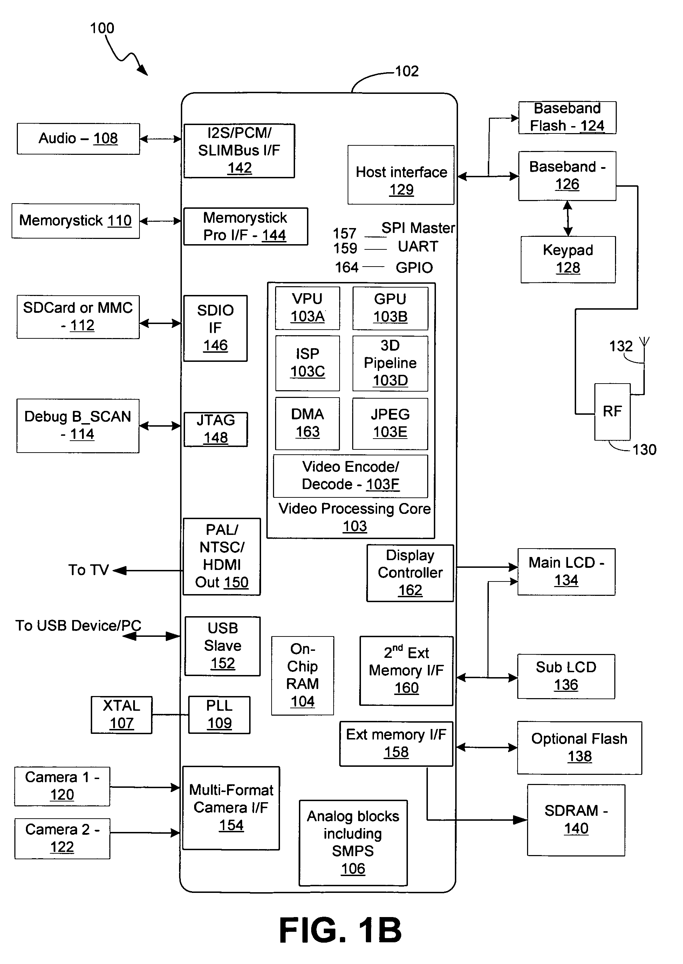

FIG. 1B is a block diagram of an exemplary multimedia processor that is operable to provide video processing, in accordance with an embodiment of the invention. Referring to FIG. 1B, the mobile multimedia processor 102 in a system 100 may comprise suitable logic, circuitry, interfaces, and/or code that may be operable to perform video and/or multimedia processing for handheld multimedia products. For example, the mobile multimedia processor 102 may be designed and optimized for video record/playback, mobile TV and 3D mobile gaming, utilizing integrated peripherals and a video processing core. The mobile multimedia processor 102 may comprise a video processing core 103 that may comprise a graphic processing unit (GPU) 103B, an image sensor pipeline (ISP) 103C, a 3D pipeline 103D, a direct memory access (DMA) controller 163, a Joint Photographic Experts Group (JPEG) encoding/decoding module 103E, and a video encoding/decoding module 103F. The mobile multimedia processor 102 may also comprise on-chip RAM 104, an analog block 106, a phase-locked loop (PLL) 109, an audio interface (I/F) 142, a Secure Digital input/output (SDIO) I/F 146, a Joint Test Action Group (JTAG) I/F 148, a TV output I/F 150, a Universal Serial Bus (USB) I/F 152, a camera I/F 154, and a host I/F 129. A memory stick I/F 144 may be optionally included in the mobile multimedia processor 102. The mobile multimedia processor 102 may further comprise a serial peripheral interface (SPI) 157, a universal asynchronous receiver/transmitter (UART) I/F 159, a general purpose input/output (GPIO) pins 164, a display controller 162, an external memory I/F 158, and a second external memory I/F 160.

The video processing core 103 may comprise suitable logic, circuitry, interfaces, and/or code that may be operable to perform video processing of data. The on-chip Random Access Memory (RAM) 104 and the Synchronous Dynamic RAM (SDRAM) 140 comprise suitable logic, circuitry and/or code that may be adapted to store data such as image or video data.

The image sensor pipeline (ISP) 103C may comprise suitable circuitry, logic and/or code that may be operable to process image data. The ISP 103C may perform a plurality of processing techniques comprising filtering, demosaic, lens shading correction, defective pixel correction, white balance, image compensation, Bayer interpolation, color transformation, and post filtering, for example. The processing of image data may be performed on variable sized tiles, reducing the memory requirements of the ISP 103C processes.

The GPU 103B may comprise suitable logic, circuitry, interfaces, and/or code that may be operable to offload graphics rendering from a general processor, such as the processor 101j, described with respect to FIG. 1A. The GPU 103B may be operable to perform mathematical operations specific to graphics processing, such as texture mapping and rendering polygons, for example.

The 3D pipeline 103D may comprise suitable circuitry, logic and/or code that may enable the rendering of 2D and 3D graphics. The 3D pipeline 103D may perform a plurality of processing techniques comprising vertex processing, rasterizing, early-Z culling, interpolation, texture lookups, pixel shading, depth test, stencil operations and color blend, for example. The 3D pipeline 103D may perform tile mode rendering in two separate phases, a first phase comprising a binning process or operation, and a second phase comprising a rendering process or operation

The JPEG module 103E may comprise suitable logic, circuitry, interfaces, and/or code that may be operable to encode and/or decode JPEG images. JPEG processing may enable compressed storage of images without significant reduction in quality.

The video encoding/decoding module 103F may comprise suitable logic, circuitry, interfaces, and/or code that may be operable to encode and/or decode images, such as generating full 1080p HD video from H.264 compressed data, for example. In addition, the video encoding/decoding module 103F may be operable to generate standard definition (SD) output signals, such as phase alternating line (PAL) and/or national television system committee (NTSC) formats.

Also shown in FIG. 1B are an audio block 108 that may be coupled to the audio interface I/F142, a memory stick 110 that may be coupled to the memory stick I/F 144 when such interface is available, an SD card block 112 that may be coupled to the SDIO IF 146, and a debug block 114 that may be coupled to the JTAG I/F 148. The PAL/NTSC/high definition multimedia interface (HDMI) TV output I/F 150 may be utilized for communication with a TV, and the USB 1.1, or other variant thereof, slave port I/F 152 may be utilized for communications with a PC, for example. A crystal oscillator (XTAL) 107 may be coupled to the PLL 109. Moreover, cameras 120 and/or 122 may be coupled to the camera I/F 154.

Moreover, FIG. 1B shows a baseband processing block 126 that may be coupled to the host interface 129, a radio frequency (RF) processing block 130 coupled to the baseband processing block 126 and an antenna 132, a basedband flash 124 that may be coupled to the host interface 129, and a keypad 128 coupled to the baseband processing block 126. A main LCD 134 may be coupled to the mobile multimedia processor 102 via the display controller 162 and/or via the second external memory interface 160, for example, and a subsidiary LCD 136 may also be coupled to the mobile multimedia processor 102 via the second external memory interface 160, for example. Moreover, an optional flash memory 138 and/or an SDRAM 140 may be coupled to the external memory I/F 158.

In operation, the mobile multimedia processor 102 may be adapted to perform video processing operations. For example, the mobile multimedia processor 102 may utilize a single LPDDR2 SDRAM to perform video processing operations that may comprise processing of 1080p formatted video data, for example. In this regard, the mobile multimedia processor 102, or at least a portion thereof, and the single LPDDR2 SDRAM may be disposed in a single package. Moreover, the mobile multimedia processor 102, or at least a portion thereof, and the single LPDDR2 SDRAM may be disposed in a single package in a stacked configuration, for example. In an embodiment of the invention, the mobile multimedia processor 102 and the single LPDDR2 SDRAM, which are disposed in the single package, are within a mobile multimedia device. In this regard, the single package may comprise an IC or chip within the mobile multimedia device.

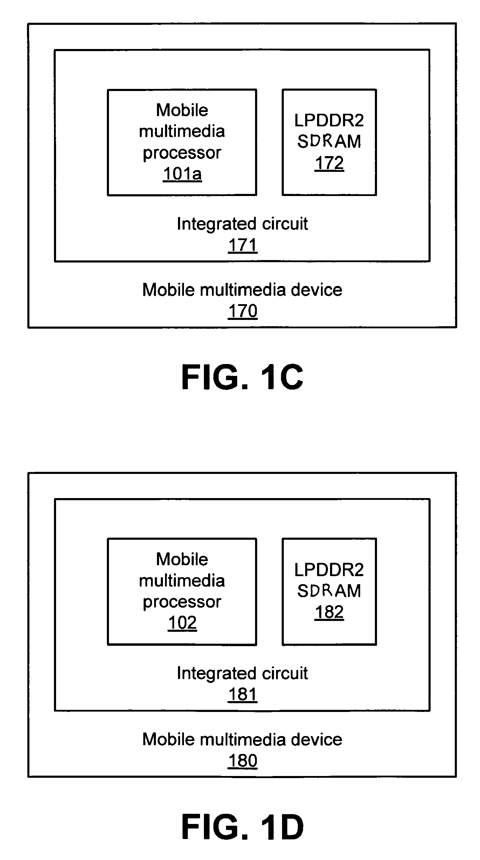

FIG. 1C is a block diagram of an exemplary multimedia processor and a LPDDR2 SDRAM in a single integrated circuit, in accordance with an embodiment of the invention. Referring to FIG. 1C, there is shown a mobile multimedia device 170 that may comprise an integrated circuit 171. The mobile multimedia device 170 may be a device such as the mobile multimedia device 105a described above with respect to FIG. 1A, for example. The integrated circuit 171 may correspond to a single package that may comprise the mobile multimedia processor 101a described above with respect to FIG. 1A and a single LPDDR2 SDRAM 172, for example. In operation, the mobile multimedia processor 101a and the single LPDDR2 SDRAM 172 in the integrated circuit 171 may be operable to process video data such as video data comprising 1080p formatted video data. The processing of video data may comprise accessing the LPDDR2 SDRAM 172 by the mobile multimedia processor 101a via, for example, a 32-bit bus.

FIG. 1D is a block diagram of an exemplary multimedia processor and a LPDDR2 SDRAM in a single integrated circuit, in accordance with another embodiment of the invention. Referring to FIG. 1D, there is shown a mobile multimedia device 180 that may comprise an integrated circuit 181. The mobile multimedia device 180 may be a device such as the mobile multimedia device 105a, for example. The integrated circuit 181 may correspond to a single package that may comprise the mobile multimedia processor 102 described above with respect to FIG. 1A and a single LPDDR2 SDRAM 182, for example. In operation, the mobile multimedia processor 102 and the single LPDDR2 SDRAM 182 in the integrated circuit 181 may be operable to process video data such as video data comprising 1080p formatted video data. The processing of video data may comprise accessing the LPDDR2 SDRAM 182 by the mobile multimedia processor 102 via, for example, a 32-bit bus.

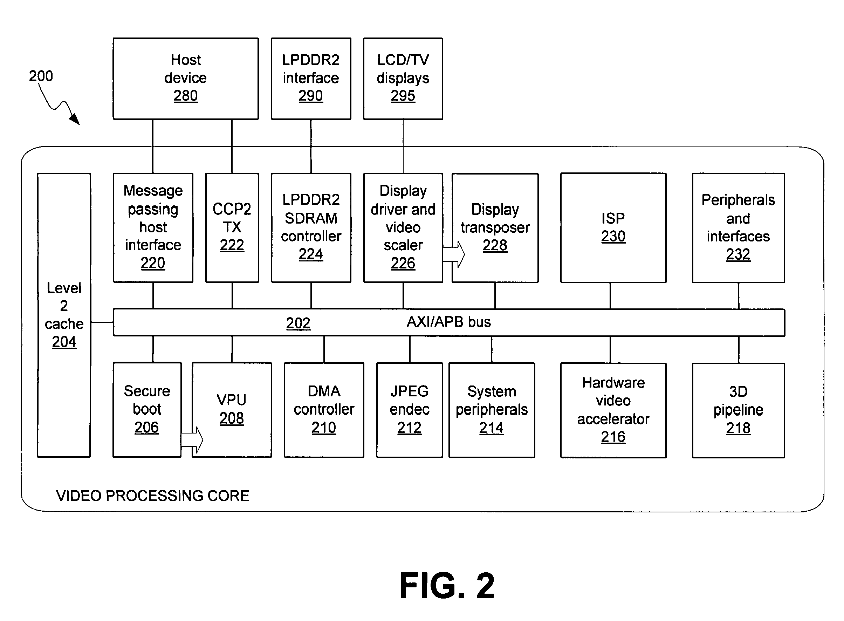

FIG. 2 is a block diagram that illustrates an exemplary video processing core architecture for use in a multimedia processor, in accordance with an embodiment of the invention. Referring to FIG. 2, there is shown a video processing core 200 comprising suitable logic, circuitry, interfaces and/or code that may be operable for high performance video and multimedia processing. The architecture of the video processing core 200 may provide a flexible, low power, and high performance multimedia solution for a wide range of applications, including mobile applications, for example. By using dedicated hardware pipelines in the architecture of the video processing core 200, such low power consumption and high performance goals may be achieved. The video processing core 200 may correspond to, for example, the video processing core 103 described above with respect to FIG. 1B.

The video processing core 200 may support multiple capabilities, including image sensor processing, high rate (e.g., 30 frames-per-second) high definition (e.g., 1080p) video encoding and decoding, 3D graphics, high speed JPEG encode and decode, audio codecs, image scaling, and/or LCD an TV outputs, for example.

In one embodiment of the invention, the video processing core 200 may comprise an Advanced eXtensible Interface/Advanced Peripheral (AXI/APB) bus 202, a level 2 cache 204, a secure boot 206, a Vector Processing Unit (VPU) 208, a DMA controller 210, a JPEG encoder/decoder (endec) 212, a systems peripherals 214, a message passing host interface 220, a Compact Camera Port 2 (CCP2) transmitter (TX) 222, a Low-Power Double-Data-Rate 2 SDRAM (LPDDR2 SDRAM) controller 224, a display driver and video scaler 226, and a display transposer 228. The video processing core 200 may also comprise an ISP 230, a hardware video accelerator 216, a 3D pipeline 218, and peripherals and interfaces 232. In other embodiments of the video processing core 200, however, fewer or more components than those described above may be included.

In one embodiment of the invention, the VPU 208, the ISP 230, the 3D pipeline 218, the JPEG endec 212, the DMA controller 210, and/or the hardware video accelerator 216, may correspond to the VPU 103A, the ISP 103C, the 3D pipeline 103D, the JPEG 103E, the DMA 163, and/or the video encode/decode 103F, respectively, described above with respect to FIG. 1B.

Operably coupled to the video processing core 200 may be a host device 280, an LPDDR2 interface 290, and/or LCD/TV displays 295. The host device 280 may comprise a processor, such as a microprocessor or Central Processing Unit (CPU), microcontroller, Digital Signal Processor (DSP), or other like processor, for example. In some embodiments, the host device 280 may correspond to the processor 101j described above with respect to FIG. 1A. The LPDDR2 interface 290 may comprise suitable logic, circuitry, and/or code that may be operable to allow communication between the LPDDR2 SDRAM controller 224 and memory. In this regard, the memory may be an LPDDR2 SDRAM (not shown) communicatively coupled to the LPDDR2 interface 290. In one embodiment of the invention, the LPDDR2 SDRAM may comprise a 32-bit access bus, for example. The LCD/TV displays 295 may comprise one or more displays (e.g., panels, monitors, screens, cathode-ray tubes (CRTs)) for displaying image and/or video information. In some embodiments, the LCD/TV displays 295 may correspond to one or more of the TV 101h and the external LCD 101p described above with respect to FIG. 1A, and the main LCD 134 and the sub LCD 136 described above with respect to FIG. 1B.

The message passing host interface 220 and the CCP2 TX 222 may comprise suitable logic, circuitry, and/or code that may be operable to allow data and/or instructions to be communicated between the host device 280 and one or more components in the video processing core 200. The data communicated may include image and/or video data, for example.

The LPDDR2 SDRAM controller 224 and the DMA controller 210 may comprise suitable logic, circuitry, and/or code that may be operable to control the access of memory by one or more components and/or processing blocks in the video processing core 200. For example, the LPDDR2 SDRAM controller 224 and/or the DMA controller 210 may be operable to control access to an LPDDR2 SDRAM communicatively coupled to the LPDDR2 interface 290. Access to the LPDDR2 SDRAM may be controlled in accordance with one or more video processing operations supported by the video processing core 200. Such video processing operations may comprise processing of video data comprising 1080p HDTV formatted video data, for example. In some embodiments of the invention, a single LPDDR2 SDRAM may be utilized with the video processing core 102.

The VPU 208 may comprise suitable logic, circuitry, and/or code that may be operable for data processing while maintaining high throughput and low power consumption. The VPU 208 may allow flexibility in the video processing core 200 such that software routines, for example, may be inserted into the processing pipeline. The VPU 208 may comprise dual scalar cores and a vector core, for example. The dual scalar cores may use a Reduced Instruction Set Computer (RISC)-style scalar instruction set and the vector core may use a vector instruction set, for example. Scalar and vector instructions may be executed in parallel.

Although not shown in FIG. 2, the VPU 208 may comprise one or more Arithmetic Logic Units (ALUs), a scalar data bus, a scalar register file, one or more Pixel-Processing Units (PPUs) for vector operations, a vector data bus, a vector register file, a Scalar Result Unit (SRU) that may operate on one or more PPU outputs to generate a value that may be provided to a scalar core. Moreover, the VPU 208 may comprise its own independent level 1 instruction and data cache.

The ISP 230 may comprise suitable logic, circuitry, and/or code that may be operable to provide hardware accelerated processing of data received from an image sensor (e.g., charge-coupled device (CCD) sensor, complimentary metal-oxide semiconductor (CMOS) sensor). The ISP 230 may comprise multiple sensor processing stages in hardware, including demosaicing, geometric distortion correction, color conversion, denoising, and/or sharpening, for example. The ISP 230 may comprise a programmable pipeline structure. Because of the close operation that may occur between the VPU 208 and the ISP 230, software algorithms may be inserted into the pipeline.

The hardware video accelerator 216 may comprise suitable logic, circuitry, and/or code that may be operable for hardware accelerated processing of video data in any one of multiple video formats such as H.264, VC-1, MPEG-1, MPEG-2, and MPEG-4, for example. For H.264, for example, the hardware video accelerator 216 may encode at full HD 1080p at 30 frames-per-second (fps). For MPEG-4, for example, the hardware video acceleration 216 may encode a HD 720p at 30 fps. For H.264, VC-1, MPEG-1, MPEG-2, and MPEG-4, for example, the hardware video accelerator 216 may decode at full HD 1080p at 30 fps or better. The hardware video accelerator 216 may be operable to provide concurrent encoding and decoding for video conferencing and/or to provide concurrent decoding of two video streams for picture-in-picture applications, for example.

The 3D pipeline 218 may comprise suitable logic, circuitry, and/or code that may be operable to provide 3D rendering operations for use in, for example, graphics applications. The 3D pipeline 218 may support OpenGL-ES 2.0, OpenGL-ES 1.1, and OpenVG 1.1, for example. The 3D pipeline 218 may comprise a multi-core programmable pixel shader, for example. The 3D pipeline 218 may be operable to handle 32M triangles-per-second (16M rendered triangles-per-second), for example. The 3D pipeline 218 may be operable to handle 1G rendered pixels-per-second with Gouraud shading and one bi-linear filtered texture, for example. The 3D pipeline 218 may support four times (4x) full-screen anti-aliasing at full pixel rate, for example.

The 3D pipeline 218 may comprise a tile mode architecture in which a rendering operation may be separated into a first phase and a second phase. During the first phase, the 3D pipeline 218 may utilize a coordinate shader to perform a binning operation. The coordinate shader may be obtained from a vertex shader at compile time, for example. In one embodiment of the invention, the coordinate shader may be obtained automatically during vertex shader compilation. The coordinate shader may comprise those portions of the vertex shader that relate to the processing of the coordinates of the vertices. Such coordinates may be utilized to, for example, control the binning operation and need not be stored for subsequent use such as during the second phase, for example.

The JPEG endec 212 may comprise suitable logic, circuitry, and/or code that may be operable to provide processing (e.g., encoding, decoding) of images. The encoding and decoding operations need not operate at the same rate. For example, the encoding may operate at 120M pixels-per-second and the decoding may operate at 50M pixels-per-second depending on the image compression.

The display driver and video scaler 226 may comprise suitable logic, circuitry, and/or code that may be operable to drive the TV and/or LCD displays in the TV/LCD displays 295. In this regard, the display driver and video scaler 226 may output to the TV and LCD displays concurrently and in real time, for example. Moreover, the display driver and video scaler 226 may comprise suitable logic, circuitry, and/or code that may be operable to scale, transform, and/or compose multiple images. The display driver and video scaler 226 may support displays of up to full HD 1080p at 60 fps.

The display transposer 228 may comprise suitable logic, circuitry, and/or code that may be operable for transposing output frames from the display driver and video scaler 226. The display transposer 228 may be operable to convert video to 3D texture format and/or to write back to memory to allow processed images to be stored and saved.

The secure boot 206 may comprise suitable logic, circuitry, and/or code that may be operable to provide security and Digital Rights Management (DRM) support. The secure boot 206 may comprise a boot Read Only Memory (ROM) that may be used to provide secure root of trust. The secure boot 206 may comprise a secure random or pseudo-random number generator and/or secure (One-Time Programmable) OTP key or other secure key storage.

The AXI/APB bus 202 may comprise suitable logic, circuitry, and/or interface that may be operable to provide data and/or signal transfer between various components of the video processing core 200. In the example shown in FIG. 2, the AXI/APB bus 202 may be operable to provide communication between two or more of the components the video processing core 200.

The AXI/APB bus 202 may comprise one or more buses. For example, the AXI/APB bus 202 may comprise one or more AXI-based buses and/or one or more APB-based buses. The AXI-based buses may be operable for cached and/or uncached transfer, and/or for fast peripheral transfer. The APB-based buses may be operable for slow peripheral transfer, for example. The transfer associated with the AXI/APB bus 202 may be of data and/or instructions, for example.

The AXI/APB bus 202 may provide a high performance system interconnection that allows the VPU 208 and other components of the video processing core 200 to communicate efficiently with each other and with external memory.

The level 2 cache 204 may comprise suitable logic, circuitry, and/or code that may be operable to provide caching operations in the video processing core 200. The level 2 cache 204 may be operable to support caching operations for one or more of the components of the video processing core 200. The level 2 cache 204 may complement level 1 cache and/or local memories in any one of the components of the video processing core 200. For example, when the VPU 208 comprises its own level 1 cache, the level 2 cache 204 may be used as complement. The level 2 cache 204 may comprise one or more blocks of memory. In one embodiment, the level 2 cache 204 may be a 128 kilobyte four-way set associate cache comprising four blocks of memory (e.g., Static RAM (SRAM)) of 32 kilobytes each.

The system peripherals 214 may comprise suitable logic, circuitry, and/or code that may be operable to support applications such as, for example, audio, image, and/or video applications. In one embodiment, the system peripherals 214 may be operable to generate a random or pseudo-random number, for example. The capabilities and/or operations provided by the peripherals and interfaces 232 may be device or application specific.

In operation, the video processing core 200 may be operable to carry out multiple multimedia tasks simultaneously without degrading individual function performance. In various exemplary embodiments of the invention, the video processing core 200 may be utilized with an LPDDR2 SDRAM to perform video processing operations. Such operations may comprise the processing of 1080p formatted video data, for example. The video processing core 200, or at least a portion thereof, and an LPDDR2 SDRAM communicatively coupled with the video processing core 200 through at least the LPDDR2 SDRAM controller 224 may be disposed in a single package. In this regard, the video processing core 200, or at least a portion thereof, and the LPDDR2 SDRAM may be disposed in a single package in a stacked configuration, for example. In an embodiment of the invention, the video processing core 200 and the single LPDDR2 SDRAM, which are disposed in the single package, are within a mobile multimedia device. The single package may comprise an IC or chip within the mobile multimedia device.

The video processing core 200 and the LPDDR2 SDRAM may be operable to implement camcorder or video recorder operations. For example, the ISP 230 may be operable to capture video data, a video codec implemented with one or more modules of the video processing core 200 may encode the captured video data, and the display driver and video scaler 226 may be utilized to preview display formatting, for example. In such operations, the VPU 208 may be utilized to perform discrete cosine transform (DCT) operations for MPEG-4 encoding and/or to provide additional software functions in the ISP 230 pipeline. The LPDDR2 SDRAM may be utilized to store and/or read data associated with one or more aspects of the camcorder or video recorder operation.

The video processing core 200 may also be operable to implement movie playback operations. In this regard, the video processing core 200 may be operable to add 3D effects to video output, for example, to map the video onto 3D surfaces or to mix 3D animation with the video. In another exemplary embodiment of the invention, the video processing core 200 may be utilized in a gaming device. In this regard, full 3D functionality may be utilized. The VPU 208 may be operable to execute a game engine and may supply graphics primitives (e.g., polygons) to the 3D pipeline 218 to enable high quality self-hosted games. In another embodiment, the video processing core 200 may be utilized for stills capture. In this regard, the ISP 230 and/or the JPEG endec 212 may be utilized to capture and encode a still image. For stills viewing and/or editing, the JPEG endec 212 may be utilized to decode the stills data and the video scaler may be utilized for display formatting. Moreover, the 3D pipeline 218 may be utilized for 3D effects, for example, for warping an image or for page turning transitions in a slide show, for example. An LPDDR2 SDRAM may be utilized with the video processing core 200 to store and/or read data associated with one or more aspects of the above-described video processing operations.

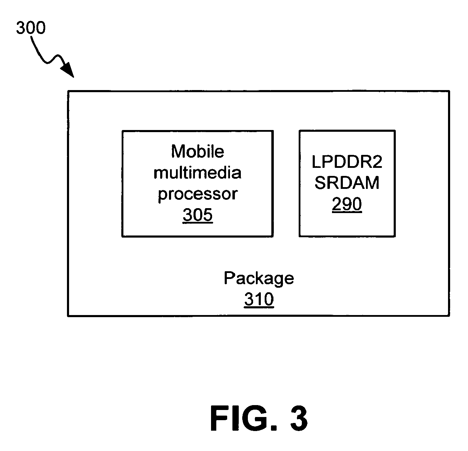

FIG. 3 is a block diagram that illustrates an exemplary single package comprising a multimedia processor and an LPDDR2 SDRAM, in accordance with an embodiment of the invention. Referring to FIG. 3, there is shown an assembly 300 that may comprise a package 310 in which a mobile multimedia processor 305 and an LPDDR2 SDRAM 290a may be disposed. The mobile multimedia processor 305 may be communicatively coupled to the LPDDR2 SDRAM 290a. In one embodiment of the invention, the mobile multimedia processor 305 may access the LPDDR2 SDRAM 290a during a video processing operation via a 32-bit bus. The mobile multimedia processor 305 may be, for example, the mobile multimedia processor 101a described above with respect to FIG. 1A or the mobile multimedia processor 102 described above with respect to FIG. 1B.

The package 310 may be made of a ceramic or a plastic substrate material, for example. The package 310 may be a type of surface mount package for use with integrated circuits such as a ball grid array (BGA) package, for example. In this regard, the package 310 may be, for example, a chip array ball grid array (CABGA), a thin chip array ball grid array (CTBGA), a very thin chip array ball grid array (CVBGA), a flip chip ball grid array (FCBGA), land grid array (LGA), or the like.

The package 310 may comprise other types of packages such as ceramic-based multi-chip modules (MCM), plastic quad flat packs (PQFP), thin small-outline package (TSOP), small outline integrated circuit (SOIC), or the like.

The package 310 may comprise packages that support stacking such as system-in-package (SiP) and three-dimensional integrated circuits, for example.

The package 310 may comprise an IC or chip. In this regard, the mobile multimedia processor 305 and the LPDDR2 SDRAM 290a may be integrated on the same IC or chip. The mobile multimedia processor 305 and the LPDDR2 SDRAM 290a may be in the package 310 on a same substrate, for example.

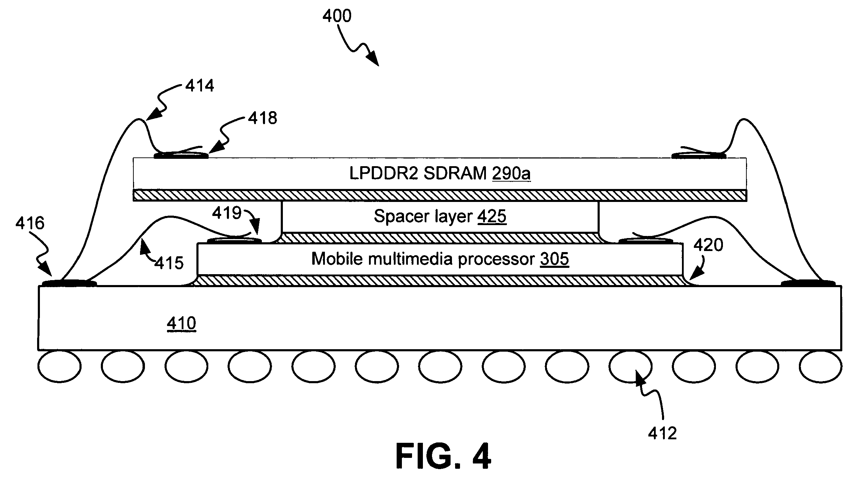

FIG. 4 is a cross-sectional view of an exemplary stacked configuration of a multimedia processor and an LPDDR2 SDRAM in a single ball grid array package, in accordance with an embodiment of the invention. Referring to FIG. 4, there is shown an assembly 400 that may comprise a package 410, a spacer layer 425, and the mobile multimedia processor 305 and the LPDDR2 SDRAM 290a described above with respect to FIG. 3.

The package 410 may be, for example, a ball grid array package. The package 410 may comprise a grid array of solder balls 412 on one surface of the package such that when the package 410 is aligned and placed on pads on a printed circuit board (PCB) and subsequently heated, the package 410 may be held together and communicatively coupled to the PCB.

In the example shown in FIG. 4, the mobile multimedia processor 305, the spacer layer 425, and the LPDDR2 SDRAM 290a may be stacked in a configuration in which the mobile multimedia processor 305 is at the bottom of the stack and the LPDDR2 SDRAM 290a is at the top of the stack. The spacer layer 425 may be placed in between substrates comprising the video processing core 200 and the LPDDR2 SDRAM 290a to provide, for example, thermal isolation. Other configurations, however, may also be utilized.

Also shown in FIG. 4, are pads 416, 418, and 419 that may be utilized to connect the various portions of the assembly 400 using bonding wires 414 and 415, for example. Moreover, a material 420 may be utilized to properly bond or fix the mobile multimedia processor 305 to the package 410. The same or different material may be utilized to bond or fix the spacer layer 425 to the mobile multimedia processor 305 and/or to bond or fix the LPDDR2 SDRAM 290a to the spacer layer 425.

The configuration, structure, and/or materials described above with respect to FIG. 4 are provided by way of example. Other embodiments of the invention, however, need not be so limited. For example, configurations in which the mobile multimedia processor 305 is at the top of the stack and the LPDDR2 SDRAM 209a is at the bottom of the stack may also be utilized. Moreover, more than one spacer layer 425 may be utilized. In this regard, spacer layers with different physical and/or thermal properties may be utilized in the assembly 400.

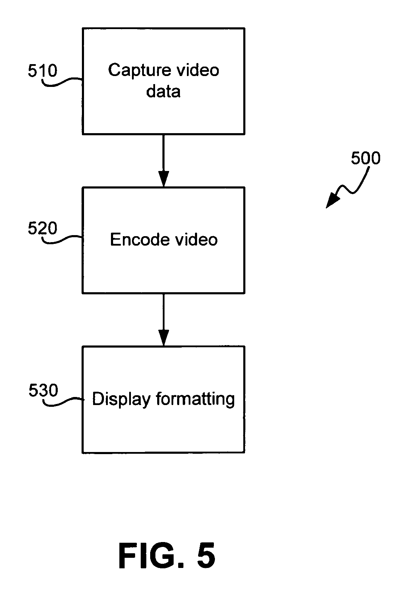

FIG. 5 is a flow chart that illustrates an exemplary usage case for processing data from a video recorder utilizing a multimedia processor and an LPDDR2 SDRAM in a single package, in accordance with an embodiment of the invention. Referring to FIG. 5, there is shown a flow chart 500. In step 510, the mobile multimedia processor 305 and the LPDDR2 SDRAM 290a, may be utilized to capture image data from a camera such as the external camera 101m in FIG. 1A or the cameras 120 and/or 122 in FIG. 1B, for example. In this regard, the mobile multimedia processor 305 may comprise a video processing core such as the video processing cores 103 and 200 described above with respect to FIGS. 1B and 2, respectively. When the video processing core of the mobile multimedia processor 305 comprises one or more modules and/or components that provide substantially similar functionality to that of the ISP 230, such one or more modules and/or components may be utilized with the LPDDR2 SDRAM to capture and/or store the image data.

In step 520, the mobile multimedia processor 305 and the LPDDR2 SDRAM 290a may be utilized to encode the captured image data. In this regard, a codec may be implemented using one or more modules and/or components of the video processing core of the mobile multimedia processor 305 and the codec may be utilized to encode the captured image data. For example, such one or more modules and/or components may be utilized for encoding captured image data by providing substantially similar functionality to that of the VPU 208 and/or the hardware video accelerator 216. In this regard, the functionality provided by may be utilized to perform DCT transforms for MPEG-4 encoding operations, for example. The functionality provided may also be utilized for additional software functions in the ISP pipeline. The LPDDR2 SDRAM 290a may be utilized to store and/or read data during the encoding of the captured image data, for example.

In step 530, the mobile multimedia processor 305 and the LPDDR2 SDRAM 290a may be utilized to process the encoded data for preview display formatting, for example. In this regard, one or more modules and/or components of the video processing core of the mobile multimedia processor 305 may provide substantially similar functionality to that of the display driver and video scalar 226 and may be utilized to perform the preview display formatting. The LPDDR2 SDRAM 290a may be utilized to store and/or read data during the preview display formatting, for example.

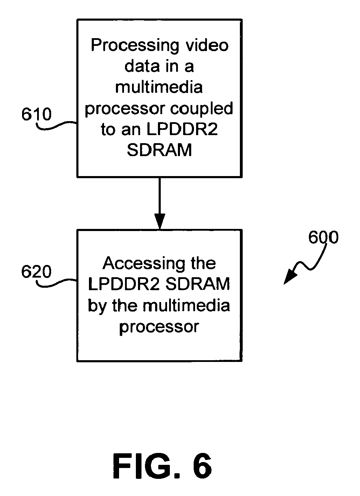

FIG. 6 is a flow chart that illustrates an exemplary video processing operation of a multimedia processor and an LPDDR2 SDRAM in a single package, in accordance with an embodiment of the invention. Referring to FIG. 6, there is shown a flow chart 600. In step 610, video data may be processed utilizing a multimedia processor, such as the mobile multimedia processor 101a in FIG. 1A, the mobile multimedia processor 102 in FIG. 1B, or the mobile multimedia processor 305 in FIG. 3, for example. Such multimedia processor may be communicatively coupled to a single LPDDR2 SDRAM, such as the LPDDR2 SDRAM 290a in FIG. 3, for example. The multimedia processor and the single LPDDR2 SDRAM may be disposed in a single package, such as the IC 171 in FIG. 1C or the IC 181 in FIG. 1D. Moreover, the multimedia processor and the single LPDDR2 SDRAM may be disposed in a single package, such as the package 310 in FIG. 3 or the package 400 in FIG. 4, for example. In step 620, the LPDDR2 SDRAM may be accessed by the multimedia processor during the processing of video data. The accessing of the LPDDR2 SDRAM may be performed as part of the processing of video data.

The processing of video data may comprise processing of video data comprising 1080p HDTV formatted data. The single LPDDR2 SDRAM may accessed by the multimedia processor via a 32-bit access bus. In an embodiment of the invention, when the multimedia processor comprises a video processing core such as the video processing core 200, for example, the LPDDR2 SDRAM may be accessed via the AXI/APB bus 202, the LPDDR2 SDRAM controller 224, and/or the LPDDR2 interface 290 of the video processing core 200.

The processing of video data may comprise pipeline processing of video data from an image sensor, such as the external camera 101m in FIG. 1A or the cameras 120 and/or 122 in FIG. 1B, for example. The processing of video data may comprise encoding the pipelined processed video data. The encoding may comprise discrete cosine transforming of the pipelined processed video data. Such discrete cosine transforming may be performed by, for example, the VPU 208 in the video processing core 200. The processing of video data may comprise formatting the encoded data for displaying in, for example, the external LCD 101p in FIG. 1A or the LCDs 134 and/or 136 in FIG. 1B.

The multimedia processor and the single LPDDR2 SDRAM described above with respect to steps 610 and 620 in the flow chart 600 may be disposed in the single package on a single substrate. The multimedia processor and the single LPDDR2 SDRAM may be disposed in a single package in a stacked configuration, such as the configuration shown in the assembly 400 in FIG. 4, for example. The stacked configuration may comprise a spacer layer, such as the spacer layer 425, for example, between a substrate comprising the multimedia processor and a substrate comprising the single LP FIG. 5 is a flow chart that illustrates an exemplary usage case for processing data from a video recorder utilizing a multimedia processor and an LPDDR2 SDRAM in a single package, in accordance with an embodiment of the invention. DDR2 SDRAM. The single package may comprise a ball grid array package, such as the package 410, for example.

Another embodiment of the invention may provide a non-transitory machine and/or computer readable storage and/or medium, having stored thereon, a machine code and/or a computer program having at least one code section executable by a machine and/or a computer, thereby causing the machine and/or computer to perform the steps as described herein for providing 1080p video with 32-bit mobile double data rate (DDR) memory.

Accordingly, the present invention may be realized in hardware, software, or a combination of hardware and software. The present invention may be realized in a centralized fashion in at least one computer system or in a distributed fashion where different elements may be spread across several interconnected computer systems. Any kind of computer system or other apparatus adapted for carrying out the methods described herein is suited. A typical combination of hardware and software may be a general-purpose computer system with a computer program that, when being loaded and executed, controls the computer system such that it carries out the methods described herein.

The present invention may also be embedded in a computer program product, which comprises all the features enabling the implementation of the methods described herein, and which when loaded in a computer system is able to carry out these methods. Computer program in the present context means any expression, in any language, code or notation, of a set of instructions intended to cause a system having an information processing capability to perform a particular function either directly or after either or both of the following: a) conversion to another language, code or notation; b) reproduction in a different material form.

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

## Claims

1. A method for video processing, the method comprising:
in a mobile communication device:
processing video data utilizing a multimedia processor communicatively coupled to a single low power double data rate memory 2 (LPDDR2) synchronous dynamic random access memory (SDRAM), wherein:
said multimedia processor and said single LPDDR2 SDRAM are disposed in a single package on a single substrate; and
said processing comprises accessing said single LPDDR2 SDRAM by said multimedia processor during said processing of video data.

2. The method according to claim 1, wherein said video data comprises 1080 progressive (1080p) high-definition television (HDTV) formatted video data.

3. The method according to claim 1, comprising accessing said single LPDDR2 SDRAM via a 32-bit wide bus access.

4. The method according to claim 1, wherein said processing comprises pipeline processing of video data from an image sensor.

5. The method according to claim 4, wherein said processing comprises encoding said pipelined processed video data.

6. The method according to claim 5, wherein said encoding comprises discrete cosine transforming of said pipelined processed video data.

7. The method according to claim 5, wherein said processing comprises formatting said encoded data for displaying.

8. The method according to claim 1, wherein said multimedia processor and said single LPDDR2 SDRAM are disposed in a stacked configuration in said single package.

9. The method according to claim 8, wherein said stacked configuration comprises a spacer layer between a substrate comprising said multimedia processor and a substrate comprising said single LPDDR2 SDRAM.

10. The method according to claim 1, wherein said single package comprises a ball grid array package.

11. A system for video processing, the system comprising:
a multimedia processor for use within a mobile communication device; and
a single low power double data rate memory 2 (LPDDR2) synchronous dynamic random access memory (SDRAM) communicatively coupled to said multimedia processor, wherein:
said multimedia processor and said single LPDDR2 SDRAM are disposed in a single package on a single substrate,
said multimedia processor is operable to process video data, and
said multimedia processor is operable to access said single LPDDR2 SDRAM during said processing of video data.

12. The system according to claim 11, wherein said video data comprises 1080 progressive (1080p) high-definition television (HDTV) formatted video data.

13. The system according to claim 11, wherein said multimedia processor is operable to access said single LPDDR2 SDRAM via a 32-bit wide access bus.

14. The system according to claim 11, wherein said multimedia processor and said single LPDDR2 SDRAM are operable to pipeline process video data from an image sensor.

15. The system according to claim 14, wherein said multimedia processor and said single LPDDR2 SDRAM are operable to encode said pipelined processed video data.
